Europäisches Patentamt

European Patent Office

Office européen des brevets

(19)

(11) **EP 1 426 777 A2**

(12) **EUROPEAN PATENT APPLICATION**

(43) Date of publication:
**09.06.2004 Bulletin 2004/24**

(51) Int Cl.7: **G01R 31/06**

(21) Application number: **03078682.6**

(22) Date of filing: **21.11.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **02.12.2002 DK 200201857**

(71) Applicant: **Kamstrup A/S
8660 Skanderborg (DK)**

(72) Inventors:
• **Brümmer, Heinz Kurt
  8220 Brabrand (DK)**
• **Hald, Flemming
  8000 Arhus C (DK)**

(74) Representative: **Plougmann & Vingtoft A/S
Sundkrogsgade 9
P.O. Box 831
2100 Copenhagen O (DK)**

(54) **An apparatus for the determination of electrical power**

(57)     The present invention provides a low cost and high accuracy apparatus for measuring total electrical power supplied by an electrical power supply system at a number of electrical phases. This is achieved by matching the phase error introduced by the means for sensing current and voltage supplied by each electrical phase. Power can hereby be calculated without error caused by the sensed current and voltage being out of phase. The phase error match can be achieved with small and low cost transformers as current and voltage sensing means. Transformers for both current and voltage sensing provides a galvanic separation at an early stage, thus enabling use of a single power calculating unit common for all phases. An electronic circuit is proposed so as to enable the power calculating unit to be powered by the voltage sensing transformers without introducing measuring inaccuracy due to variation over time of the power required by the power calculating unit.

Fig. 1

EP 1 426 777 A2

## Description

FIELD OF THE INVENTION

The present invention relates to an apparatus for determining electrical power supplied by an electrical power supply system comprising a plurality of phases. The power determining apparatus relates to the type using a transformer for sensing the current provided by each phase.

BACKGROUND OF THE INVENTION

In the field of electrical power measurement for domestic use shunt resistors have been widely used for the generation of an electrical representation of the current supplied by a power supply system. A shunt resistor connected in series with a phase in a power supply system provides a linear method of generating a voltage proportional to the current supplied by the phase. Having information regarding the voltage potential of the phase the power supplied by the phase can be determined.

EP 0 969 286 A2 describes a power meter using shunt resistors as current sensing means. However, a disadvantage of using shunt resistor is related to the fact, that measurement circuit connected to the shunt resistor is drawn to the voltage potential of the phase. Therefore, it is not possible to directly connect the sensed signals to a calculating unit without galvanic separation means. In EP 0 969 286 A2 a galvanic separation between power supply system and measurement system is provided by opto-couplers. However, this solution has the disadvantage that a power calculating unit is necessary for each phase of the power supply system. Thus, the design requiring a power calculating unit for each phase makes the power meter bulky and expensive to produce.

Alternatively, a transformer can be used for measuring the current provided by the power supply system, and in addition provide a galvanic separation between the power supply voltage and the measuring equipment. However, it is a disadvantage of such a system that, typically, a current transformer of a reasonable size will introduce a significant phase error due to a too low self-induction. A phase error of approximately 5°-10° is typical, and it further depends on a number of parameters, among these is the temperature of the current transformer. This creates problems when determining the power provided by the phase of the supplying system, since this power is determined as a product of measured current and voltage. If the current is measured with a significant phase error, the power will be determined with an unacceptable inaccuracy. This problem can either be solved by providing a very large, and therefore expensive, current transformer with a negligible phase error, or alternatively the phase error introduced by the current transformer needs to be compensated for. Since the phase error depends on the temperature of the transformer it is not possible to compensate for the phase error merely by calibration.

WO 01/51937 describes a power meter using a transformer for measuring the current provided by a phase of a power supply system. Using a current transformer for measuring the current provided by the phase solves the problem of galvanic separation between the power supply system and the measurement system. WO 01/51937 describes a solution to the above-mentioned problem by providing a "pulsing" RC circuit for compensating the phase error introduced by the current transformer.

However, it is a disadvantage of the electricity meter described in WO 01/51937 that it does not completely compensate for the phase error introduced by the current transformer, since it does not take into account, for instance, the temperature variation of the phase error. Consequently, the determined power with such a meter may still be quite inaccurate. Taking the temperature variation into account may be done by introducing another electronic circuit connected to a transducer mounted on the current transducer for measuring its temperature. However, such a meter becomes quite complicated, bulky, and the economical advantage of using a small and inexpensive current transformer may be lost to compensating electronics. In addition, the large number of electronic circuits reduces the reliability and long-term stability of the meter.

SUMMARY OF THE INVENTION

It may be seen as an object of the present invention to provide an apparatus for determining electrical power provided by a power supply system having at least one electrical phase. The apparatus must be accurate, long-term stable, and at the same time suited for low cost production.

In a first aspect, the invention relates to an apparatus for determining electrical power supplied by an electrical power supply system having at least one phase, the apparatus comprising:

for each phase:

- current sensing means for determining the current supplied by a phase, the current sensing means providing galvanic separation between the apparatus and the power supply system, the current sensing means further introducing a phase error,

- voltage sensing means for determining the voltage supplied by the phase, the voltage sensing means providing galvanic separation between the apparatus and the power supply system, the voltage sensing means further introducing a phase error, and

- a power calculating unit for determining, from the determined current(s) and voltage(s) supplied by the at least one phase, a total power supplied by the electrical power supply system,

wherein the phase error introduced by the current sensing means is compensated by the phase error introduced by the voltage sensing means.

Introducing the possibility of galvanically separating the current sensing means and the input of the voltage sensing means provides the possibility of reducing the number of power calculating units. Only one power calculating units is necessary for an apparatus being able to determine the total power provided by a plurality of phases.

The fact that the phase error introduced by the current sensing means is compensated by the phase error introduced by the voltage sensing means has a number of advantages. It eliminates the need for a separate circuit for the compensation, which again makes the apparatus simpler and thus easier and less expensive to produce. At the same time the apparatus becomes more long-term stable since a circuit is eliminated. In addition, there are no demands to the phase error introduced by the current sensing means. Thereby, it is possible to use a small and low cost current transformer with a corresponding large phase error. Additionally, it is also possible to use a small and low cost voltage transformer.

Preferably, the phase error is compensated in that the voltage sensing means is adapted to introduce a phase error substantially equal to the phase error introduced by the current sensing means. Hereby, the inaccuracy of the determined power provided by the power supply system, due to the phase error introduced by the current sensing means is substantially eliminated.

Preferably, the current sensing means and the voltage sensing means are mounted so as to be exposed to substantially the same temperature. Hereby, the temperature dependence of the phase error introduced by the current sensing means will substantially be eliminated, since the temperature dependence of the phase error introduced by the current sensing means will be substantially equal to that of the current sensing means.

Preferably, the current sensing means comprises a current transformer, and preferably the voltage sensing means comprises a voltage transformer.

In a preferred embodiment of the apparatus, the voltage transformer supplies electrical power to the power calculating unit. Furthermore, the apparatus preferably comprises an electronic circuit for compensating a phase error in the voltage transformer caused by a variable electrical power load of the power calculating unit and possible other auxiliary equipment such as data communication equipment. Preferably, the electronic circuit comprises active components.

In a preferred embodiment the apparatus comprises two current sensing means, and two voltage sensing means for determining the total power supplied by a two phase electrical power supply system. In another preferred embodiment, the apparatus comprises three current sensing means, and three voltage sensing means for determining the total power supplied by a three phase electrical power supply system.

In a second aspect, the invention relates to a method for determining electrical power supplied by an electrical power supply system having at least one phase, the method comprising the steps of:

- sensing a current supplied by a phase, wherein the sensed current has a first phase error relative to the current supplied by the phase,

- sensing a voltage supplied by the phase, wherein the sensed voltage has a second phase error relative to the voltage supplied by the phase, the second phase error compensating the first phase error, and

- determining the electrical power from the sensed current(s) and voltage(s).

Preferably the second phase error is substantially equal to the first phase error. Furthermore the method may comprise determining an electrical power supplied by a phase being by multiplying the sensed current supplied by the phase and the sensed voltage supplied by the phase. The method may comprise determining the electrical power supplied by the electrical power supply system by summing the electrical power supplied by each of the at least one phase.

BRIEF DESCRIPTION OF THE DRAWINGS

In the following, the present invention is described in further details with reference to the accompanying figures, wherein

fig. 1 shows a schematic diagram of the present invention in a two-phase embodiment, and

fig. 2 shows a preferred embodiment of a circuit for compensating the phase error introduced by the varying power supplied to the power calculating unit and auxiliary equipment.

While the invention is susceptible to various modifications and alternative forms, specific embodiments have been shown by way of example in the drawings and will be described in detail herein. It should be understood, however, that the invention is not intended to be limited to the particular forms disclosed. Rather, the invention is to cover all modifications, equivalents, and alternatives falling within the spirit and scope of the invention as defined by the appended claims.

DETAILED DESCRIPTION OF THE INVENTION

In a preferred embodiment according to the present invention, an apparatus uses, for determining the power provided by each phase, a transformer for sensing the current and a transformer for sensing the voltage. Hereby the galvanic separation is provided both for the sensed current and voltage signal, and it is possible to lead the sensed current and voltage signals directly to one power calculating unit.

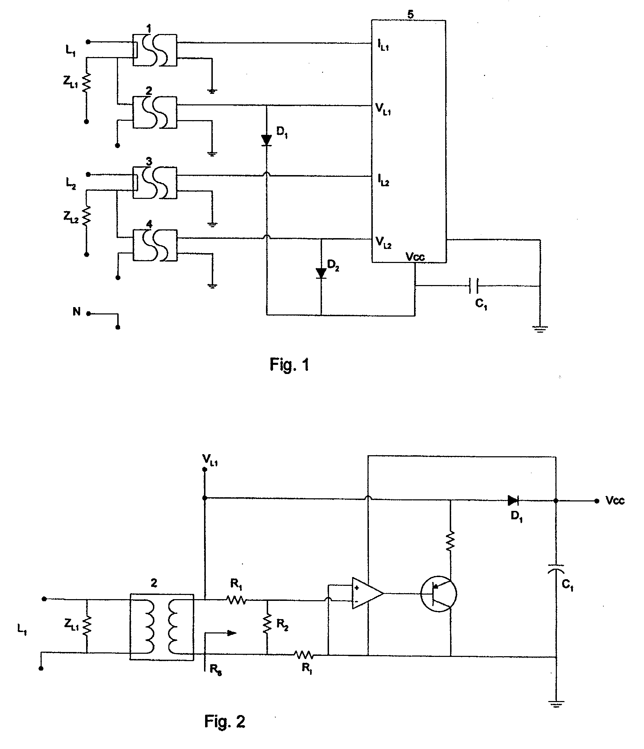

Figure 1 shows a schematic diagram of the elements in such a simple embodiment for determining the power supplied by a two-phase power supply with the phases denoted $L_1$ and $L_2$. To determine the current in a phase $L_1$, a current transformer 1 is connected with its primary winding in series with the load so as to generate a voltage proportional to the current supplied by that phase at its secondary winding. This signal is sent to the power calculating unit 5.

In figure 1, a second transformer 2 is connected with its primary winding between $L_1$ and neutral for sensing the voltage supplied by $L_1$ so as to generate a voltage proportional to the voltage supplied by $L_1$ at its secondary winding. This signal is also sent to the power calculating unit 5. The voltage can either be sensed directly over the load, $Z_{L1}$, such as shown in figure 1, or it can be sensed over the $Z_{L1}$ and the current transformer 1. The difference between these two methods for sensing the voltage is whether the power consumed by the measuring equipment is included in the measured power or not. For most applications this difference is small.

For phase $L_2$ a current transformer 3 and a voltage transformer 4 are used to sense the current and voltage supplied by $L_2$ similar to the procedure described above for $L_1$. Thus, the power calculating unit is supplied with both currents and voltages supplied by $L_1$ and $L_2$. According to the invention, the current and voltage sensed for each phase are substantially in phase, since preferably the phase error introduced by the current transformer is equal to the phase error introduced by the voltage transformer. Therefore, it is a simple task, in the power calculating unit 5, to calculate the power supplied by $L_1$ simply as the product of the sensed current $I_{L1}$ and the sensed voltage $V_{L1}$. In a similar manner the power supplied by $L_2$ is determined as the product of the sensed current $I_{L2}$ and the sensed voltage $V_{L2}$. The total power determined in the power calculating unit 5 is finally determined as a sum of the power supplied by $L_1$ and $L_2$. Integrating the determined total power over time results in the consumed energy. This consumed energy can then be communicated to a display visible to a consumer thus allowing the consumer to monitor consumed electrical energy. The display may be a LED or a LCD display screen adapted to display digits so as to form a figure representing the consumed electrical energy.

In a preferred embodiment of the present invention, the current transformer and the voltage transformer should be exposed to substantially the same temperature in order to avoid temperature induced phase error differences. This can be obtained by positioning the two transformers close to each other, or, preferably, integrating the two transformers in the same housing.

In general, an apparatus according to the present invention can be made using small low cost current transformers, since the size of the phase error introduced by the current transformer is not important as long as the same size of phase error is introduced also by the voltage transformer. This aspect also implies, that small low cost voltage transformers can be used, since, in order to have a phase error equal to that of the current transformers, the voltage transformers will also be quite small and therefore low cost.

The phase error match between current transformer 1,3 and voltage transformer 2,4 is easy to establish for a production series. An acceptable phase error match can be obtained with standard low cost production series.

In a preferred embodiment, the necessary power for the power calculating unit 5 is supplied by the secondary winding of the voltage transformers 2,4. The power may be supplied by power from one voltage transformer only. However, preferably, the power calculating unit 5 is supplied with power from the voltage transformers 2,4 for all phases, thereby allowing the apparatus to function even though only one single phase of the power supply system is active. In general, though, this will induce a load of the voltage transformers 2,4 - a load that may vary over time, for instance in case switching from a situation with 3 phases being active to a situation where the entire power to the power calculating unit 5 must be supplied by the voltage transformer 2,4 of a single phase. This load of the voltage transformer 2,4 due to driving the power calculating unit 5 may therefore, in general, result in a phase error introduced by the voltage transformer 2,4 that may vary over time, thus, introducing an unacceptable time varying inaccuracy in the determined power provided by the phase.

For some applications, the inaccuracy introduced by the time varying load is negligible. However, for some applications the inaccuracy may be significant. For instance in applications where the power calculating unit 5 comprises a transmitter for transmitting measured data to external equipment, a significant extra load of the voltage transformers 2,4 may occur when driving such transmitter. Consequently, the phase error of the voltage transformers 2,4 will change, depending on the amount of time transmitting data. The calculating unit 5 may also deliver power to drive a display for displaying the measured data. The power for driving the display may also in general vary over time. For example different figures representing the consumed energy may require more power to be displayed than other figures. Also features on the display such as light may give rise to different power consumption.

Figure 2 shows a diagram of the voltage transformer 2 of a phase L1 connected to a preferred electronic circuit for eliminating the above-mentioned time varying phase error introduced by the voltage transformer 2 supplying the supply power to the power calculating unit 5. The circuit comprises standard components such as 4 resistors, a transistor, and operational amplifier.

The supply voltage $V_{cc}$ to be supplied to the power calculating unit 5 is the voltage $V_{L1}$ from the secondary winding of the voltage transformer 2 connected via a diode. The remaining components of the circuit serves to keep the load seen from the secondary voltage transformer 2 constant. This load, $R_b$, is given by:

$$R_b = [R_l * (R_1 + R_2)]/R_2,$$

and thereby determined only from the three resistors $R_1$, $R_2$ and $R_l$, and it is thus independent of the load from the power calculating unit 5 and possible other equipment powered by or in parallel with the calculating unit 5. This implies that the load of the voltage transformer becomes constant over time. Even though the described circuit serves to equalise the time variation of the load of the voltage transformer this load will result in a phase error, a phase error that will influence the sensed voltage. However, since this phase error is constant and known, it is possible to take it into account by selecting the voltage transformer properly so as to make its phase error match the current transformer.

In case of power supply systems comprising more phases, similar circuits to the one shown in figure 2 must be connected to each voltage transformer.

Measurement apparatuses according to the present invention may be applied in many different application fields. They may be used for measurement of electrical power or electrical energy supplied by an electrical power supply system having one, two, three or even more phases. Especially in case of two or more phase systems a measurement apparatus according to the present invention can be made simple and low cost since only one calculation unit common for all phases is required.

An example of an application is within electrical power installations for households. Normally, such installations comprise measurement equipment for determining consumed electrical energy supplied by the electrical power supply system in order to determine the amount of kWh consumed during a period of time. This can be used by the supplier to invoice the consumer, or it can be used by the consumer to monitor the total energy consumed by his/her electrical devices such as lighting, TV sets, computers, domestic appliances etc. Most often the measured data is displayed on a display screen integrated with the measurement apparatus as a figure representing consumed electrical power in kWh since installation of the measurement apparatus. The measurement apparatus may have means for transmitting measured data to a receiver thus enabling the receiver to monitor consumed energy at a distant consumer.

The principles according to the present invention may also be used to measure produced electrical energy such as produced by wind turbines, gas or steam turbines, gas or diesel fuel engines driving electrical generators.

**Claims**

1. An apparatus for determining electrical power supplied by an electrical power supply system having at least one phase, the apparatus comprising:

    for each phase:

    - current sensing means for determining the current supplied by a phase, the current sensing means providing galvanic separation between the apparatus and the power supply system, the current sensing means further introducing a phase error,

    - voltage sensing means for determining the voltage supplied by the phase, the voltage sensing means providing galvanic separation between the apparatus and the power supply system, the voltage sensing means further introducing a phase error, and

a power calculating unit for determining, from the determined current(s) and voltage(s) supplied by the at least one phase, a total power supplied by the electrical power supply system, wherein the phase error introduced by the current sensing means is compensated by the phase error introduced by the voltage sensing means.

2. An apparatus according to claim 1, wherein the voltage sensing means is adapted to introduce a phase error substantially equal to the phase error introduced by the current sensing means.

3. An apparatus according to claims 1 or 2, wherein the current sensing means and the voltage sensing means are mounted so as to be exposed to substantially the same temperature.

4. An apparatus according to any of the preceding claims, wherein the current sensing means comprises a current transformer.

5. An apparatus according to any of the preceding claims, wherein the voltage sensing means comprises a voltage transformer.

**6.** An apparatus according to claim 5, wherein the voltage transformer of at least one phase is connected to the power calculating unit for supplying electrical power to the power calculating unit.

**7.** An apparatus according to claim 6, wherein the voltage transformers of all phases of the power supply system are connected to the power calculating unit for supplying electrical power to the power calculating unit.

**8.** An apparatus according to any of claims 6 or 7, further comprising an electronic circuit for compensating a phase error in the voltage transformer caused by a time dependent electrical power load of the power calculating unit.

**9.** An apparatus according to claim 8, wherein the electronic circuit comprises active components.

**10.** An apparatus according to any of the preceding claims, wherein the apparatus comprises two current sensing means, and two voltage sensing means for determining the total power supplied by a two phase electrical power supply system.

**11.** An apparatus according to any of the preceding claims, wherein the apparatus comprises three current sensing means, and three voltage sensing means for determining the total power supplied by a three phase electrical power supply system.

**12.** Method for determining electrical power supplied by an electrical power supply system having at least one phase, the method comprising the steps of:

- sensing a current supplied by a phase, wherein the sensed current has a first phase error relative to the current supplied by the phase,

- sensing a voltage supplied by the phase, wherein the sensed voltage has a second phase error relative to the voltage supplied by the phase, the second phase error compensating the first phase error, and

- determining the electrical power from the sensed current(s) and voltage(s).

**13.** Method according to claim 12, wherein the second phase error is substantially equal to the first phase error.

**14.** Method according to any of claims 12 or 13, wherein the determining of the electrical power supplied by a phase comprises the step of multiplying the sensed current supplied by the phase and the sensed voltage supplied by the phase.

**15.** Method according to any of claims 12-14, wherein the determining of the electrical power supplied by the electrical power supply system comprises the step of summing the electrical power supplied by each of the at least one phase.

Fig. 1

Fig. 2